Europäisches Patentamt

European Patent Office

Office européen des brevets

(19)

(11) Publication number: **0 209 986**
A2

(12)

# EUROPEAN PATENT APPLICATION

(21) Application number: 86304779.1

(22) Date of filing: 20.06.86

(51) Int. Cl.⁴: **H 01 L 29/743**
H 01 L 29/06, H 01 L 21/268

(30) Priority: 20.06.85 US 747085

(43) Date of publication of application:
28.01.87 Bulletin 87/5

(84) Designated Contracting States:
BE DE FR GB

(71) Applicant: WESTINGHOUSE ELECTRIC CORPORATION
Westinghouse Building Gateway Center
Pittsburgh Pennsylvania 15222(US)

(72) Inventor: Przybysz, John Xavier
168 Deerfield Drive
Pittsburgh Pennsylvania 15668(US)

(72) Inventor: Toth, Vincent Andrew
4 Glenshire Drive
Harrison City Pennsylvania 15636(US)

(74) Representative: van Berlyn, Ronald Gilbert
23, Centre Heights
London, NW3 6JG(GB)

(54) Thyristors protected against overvoltage.

(57) Thyristor which is self-protected against an overvoltage by a cavity formed in an auxiliary gate region and a process for making such a thyristor.

EP 0 209 986 A2

## IMPROVEMENTS IN OR RELATED TO THYRISTORS

This invention relates to overvoltage self-protected thyristors.

Typically overvoltage protection of a thyristor employs an avalanche current in the gate region to trigger the thyristor. The avalanching is achieved by etching a deep well, approximately 10 mils, in the gate region, during processing of a silicon wafer, the etching usually occurring after an aluminum diffusion and before a gallium diffusion is carried out. The avalanche voltage is determined by the depth and profile of the etched well.

The use of avalanching for self-protection will succeed or fail depending upon whether the avalanche voltage is less than or more than the edge breakdown voltage of the device.

The use of avalanching necessarily involves some derating of the electrical parameters of the device. Particularly, there is a derating of the forward blocking voltage, $V_{DRM}$, along with an attendant increase in forward drop, $V_F$, for the same $V_{DRM}$.

A major shortcoming of this prior art is the difficulty of controlling the subsequent gallium diffusion, after the etching of the well, to obtain the necessary curvature of the forward blocking junction.

The deep well prior art is discussed in "Thyristors With Overvoltage Self-Protection", J. X. Przybysz and E. S. Schlegel, 1981 IEDM, pgs. 410-413.

Two prior art methods of overvoltage protection involve using (1) a thinned anode base for controlling $V_{BO}$ location and voltage level, and (2) a curved forward blocking junction.

Both of these methods require building in the protection before the thyristor is completed and its parameters measured.

A deep well that results in avalanching at 2800 volts provides no protection to a thyristor which experiences edge breakdown at 2700 volts. On the other hand, a 2800 voltage avalanche is too much derating for a thyristor which could block 3200 volts.

The deep well avalanche method leaves the process engineer the choice between high yield with greatly derated thyristors or a low yield with only slightly derated devices.

The curved junction technique frequently results in low yields due to the difficulty in masking p-type diffusions.

For thin anode base and curved junction technique for achieving overvoltage protection are discussed in "Controlled Thyristor Turn-On For High DI/DT Capability", V.A.K. Temple, 1981 IEDM, pgs. 406-409.

The use of auxiliary thyristors and inhomogeneous or heterogeneous doping of the n-type base region is discussed in "A Thyristor Protected Against di/dt Failure At Breakdown Turn-On", P. Voss, Solid State Electronics, 1974, Vol. 17, pgs. 655-661.

U.S. Patent Specification No. 4,003,072 teaches curved junctions as a means of overvoltage protection.

"A New Bipolar Transistor-GAT", Hisao Kondo and Yoshinori Yukimoto, IEEE Transactions On Electronic Devices, Vol. Ed. 27 No. 2, Feb. 1980, pgs. 373-379 is a typical example of prior art teachings of a transistor in which the base region has portions extending deeper into the collector region that the remainder of the base region to contact the depletion region.

3                 **0209986**

Accordingly, the present invention resides in an overvoltge self-protected thyristor which comprises a body of semiconductor material having a top surface, a bottom surface and an edge portion extending between said top and bottom surfaces, characterized in that said thyristor has a cathode base region adjacent to a cathode emitter region, an anode base region adjacent to said cathode base region and an anode emitter region adjacent to said anode base region with a p-n junction between adjacent regions, said cathode emitter region being segmented and extending from said top surface into said body a predetermined first distance, said cathode base region extending from said top surface, where it surrounds said segments of said cathode emitter region, into said body a predetermined second distance, said predetermined second distance being greater than said predetermined first distance, at least one auxiliary gate region extending from said top surface into said body a distance less than said predetermined second distance and being spaced apart from said cathode emitter region and surrounded by said cathode base region within said thyrister, a p-n junction between said auxiliary gate region and said cathode base region, a first metal electrode disposed on and affixed to a portion of said top surface of said body in ohmic electrical contact with a portion of both said cathode emitter region and said cathode base region, a second metal electrode disposed on and affixed to a portion of said top surface of said body in ohmic electrical contact with said cathode base region, and a third metal electrode disposed on and affixed to a portion of said top surface of said body in ohmic electrical contact with a portion of both said auxiliary gate region and said cathode base region, said first, second and third metal electrodes being spaced apart from each other on said top surface, a fourth metal electrode disposed on and affixed to said bottom surface of said body in ohmic electrical contact with said anode emitter region, and walls of said auxiliary gate region forming a cavity within the auxiliary gate region, the cavity extending from the top surface of the body through said auxiliary gate region and into said cathode base region an empirically determined distance.

The invention also includes a process for providing overvoltage self-protection in a thyristor having a cathode emitter region, a cathode base region, an anode base region, an anode emitter region and an auxiliary gate region disposed within said cathode base region and extending to a major surface of said thyristor, characterized by connecting a means for measuring the IV characteristic of the thyristor between the anode emitter and the cathode emitter of the thyristor and forming a cavity in said auxiliary gate region with a laser while continuing to monitor the IV characteristic of the thyristor.

In order that the invention can be more clearly understood, convenient embodiments thereof will now be described, by way of example, with reference to the accompanying drawings in which:

Figure 1 is a side view, in section, of a prior art thyristor;

Figure 2 is a side view, in section, of a thyristor prior to processing;

Figure 3 is a side view of the thyristor of Figure 2 after processing;

Figure 4A, 4B and 4C are schematic views of the thyristor of Figure 1 showing how self-protection functions in the latter; and

Figure 5A and 5B are schematic views of the thyristor of Figure 3, showing how self-protection functions in the latter.

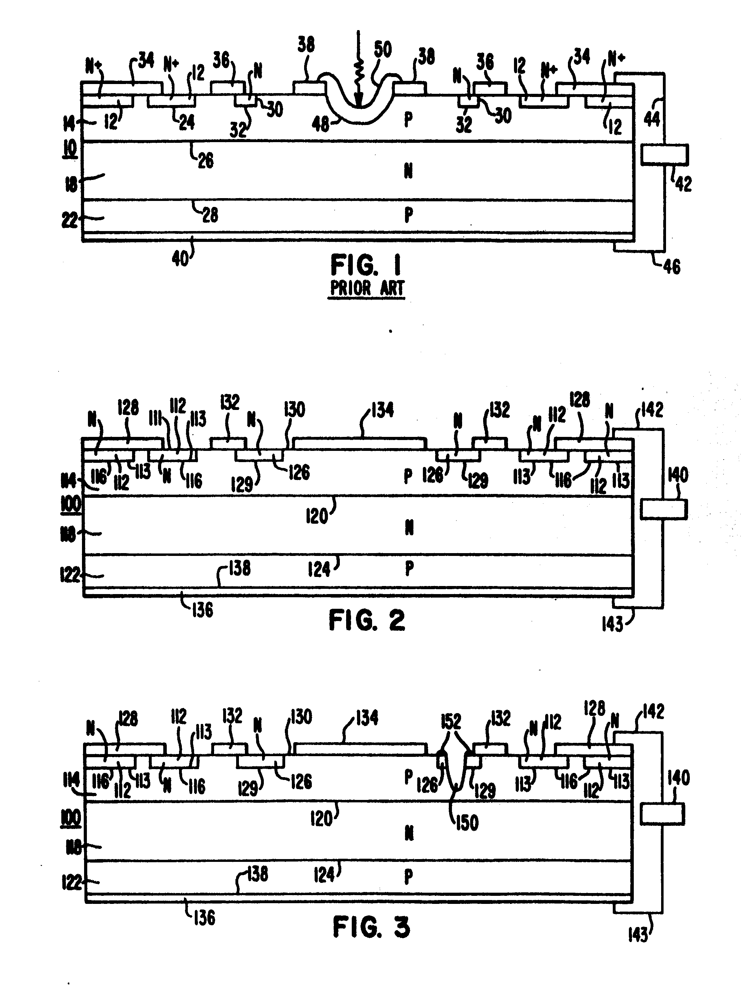

Referring to Figure 1, thyristor 10 has four adjacent regions 12, 14, 18 and 22. Region 12 is of n+ type conductivity and functions as a segmented cathode emitter. Region 14 is of p-type conductivity and functions as the cathode base region. Region 18 is an n type conductivity anode base region and region 22 is a p-type conductivity anode emitter region. There are p-n junctions 24, 26 and 28 respectively between regions 12, 14, 18 and 22.

There is also an n-type conductivity auxiliary emitter or floating gate region 30 formed in the cathode base region 14 and spaced apart from the cathode emitter region 12. There is a p-n junction 32 between regions 30 and 12.

There is an aluminum ohmic emitter contact 34 affixed to and in ohmic electrical contact with the segments of cathode emitter region 12 and base region 14.

The device 10 has a second aluminum ohmic contact 36 affixed to auxiliary emitter or floating gate region 30 and cathode base region 14.

A circular or ring gate contact 38 is disposed on the top surface of the device 10 in ohmic electrical contact with cathode base region 14.

A molybdenum contact 40 is affixed to the bottom surface of the device 10 in ohmic electrical contact with anode emitter region 22.

A curve tracer 42 is electrically connected between the cathode emitter contact 34 and the anode emitter contact 40 by electrical conductors 44 and 46 respectively.

A laser is then used to pulse the thyristor 10 at the center of the top surface. The pulsing is carried out on the top surface between the ring gate contact 38 and results in the formation of a well 48 in the anode base region 14.

The IV characteristic of the thyristor 10 is measured after each pulse or after a few pulses at the beginning and then after each pulse to determine the blocking voltage. The laser pulsing is continued until the desired blocking voltage is realized.

The lasers recommended are a YAG laser and a ruby laser.

The well 48 may also be formed by means other than a laser, for example, by drilling or abrading.

Following the formation of the well, a piece of solder 50 is disposed in the well and melted _in situ_. The quantity of solder used must be sufficient to cover the bottom of the well and extend up to and make contact with gate electrode 38.

The melting of the solder may be accomplished by heating with a $CO_2$ laser.

Upon re-solidification the solder 50 comprises an electrical contact between the bottom of the well and gate electrode or contact 34. The contact between the solder and the silicon, at the bottom of the well, may be an ohmic contact or a Schottky contact.

Any suitable metal solder can be used as long as it makes good electrical contact to the silicon and the gate contact or electrode.

Referring to Figure 2, thyristor 100 comprises a semiconductor material, preferably silicon, having a segmented cathode emitter region 112 which is of N+ type conductivity doped to a surface 111 concentration of from $10^{19}$ to $10^{20}$ atoms/cc and with a doping concentration of about $6 \times 10^{16}$ atoms/cc at its other major surface 113. Typically, the cathode emitter region 112 has a thickness of from 15 to 20 microns. There is a cathode base region 114 adjacent to the cathode emitter region. The cathode base region 114 is of p-type conductivity and doped to a surface concentration of from $5 \times 10^{17}$ to $10^{19}$ atoms/cc. Typically, the cathode base region has a thickness of from 70 to 90 microns. There is a p-n junction 116 between regions 112 and 114.

Adjacent to the cathode emitter base region 114 is an anode base region 118. The anode base region 118 is of n-type, 55 ohm-cm conductivity. The thickness of the anode base region is dependent on the breakdown voltage capability desired for the thyristor. Typically, the anode base region 118 will have a thickness of one micron from each 10 volts of breakdown voltage desired. A thickness of 230 microns is typical for this type of thyristor.

There is a p-n junction 120 between regions 114 and 118.

Anode emitter region 122 is adjacent to the anode base region 18. The anode emitter region 122 is of p+ type conductivity and is doped to a surface concentration of from $5 \times 10^{17}$ to $10^{19}$ atoms/cc. Typically, the anode base region has a thickness of from 70 to 90 microns and normally is of the same thickness as p-type region 114.

There is a p-n junction 124 between regions 116 and 122.

There is also an auxiliary emitter, floating gate region or dynamic gate region 126, all three terms being used interchangeably by those skilled in the art, formed in the cathode base region 114 and spaced apart from the segments of the cathode emitter region 112. The auxiliary emitter, floating gate, or dynamic gate region 126 is of n-type conductivity and doped to a surface concentration of from $10^{19}$ to $10^{20}$. There is a p-n junction 129 between regions 26 and 12.

An aluminum ohmic contact 128, serving as an emitter contact, is affixed to, and in ohmic electrical contact with the segments of the cathode emitter regions 112 on a portion of top surface 130 of the thyristor 110 and is also in ohmic electrical contact with base region 114. This in effect electrically shorts regions 112 and 114.

A second aluminum ohmic contact 132 is affixed to the auxiliary emitter, floating gate region or dynamic gate region 126 on top surface 130 of the thyristor 100. The ohmic contact 132 is in ohmic electrical contact with both the auxiliary emitter region 126 and the cathode base region 114 and bridges the p-n junction 129 where the junction 129 intersects surface 130.

A gate contact 134 is disposed on surface 130 in ohmic electrical contact with cathode baser region 114.

The contacts 128, 132 and 134 all disposed on portions of top surface 130 of the thyristor 100 are spaced apart from each other as shown in Figure 2.

An anode emitter contact 136, preferably of molybdenum, is affixed to bottom surface 138 of the thyristor 100 in ohmic electrical contact with the anode emitter region 122.

It should be understood that the thyristor 100 of Figure 2 is a usable thyristor representative of the type sold by Westinghouse under the designation T620.

In providing overvoltage self-protection in thyristor 100, a curve tracer 140 is electrically connected between the cathode emitter contact 128 and the anode emitter contact 136 by electrical conductors 142 and 143, respectively. A suitable curve tracer is one sold commercially by Tektronix and designated as Curve Trace 576.

With the thyristor 100 connected to the curve tracer 140 the IV characteristic of the thyristor 100 is determined.

With reference to Figure 3, a laser is used to pulse the thyristor 100 thereby forming a cavity 150. The cavity 150 is formed in a portion of the auxiliary emitter region 126 not covered by contact 132.

The IV characteristic of the thyristor is measured after each pulse or after a few pulses at the beginning and then after each pulse to determine the blocking voltage. The laser pulsing is continued until the desired blocking voltage is realized.

The laser used is, conveniently, an Excimer laser with a krypton fluoride active medium. The laser is operated in an inert atmosphere, preferably an argon atmosphere.

The pulse width of the laser is approximately ten nanoseconds and energy per pulse is from 8 to 16 millijoules depending on the focusing lens employed.

The lens preferred for use is either a 10 or 14 cm. quartz or calcium fluoride lens.

The laser beam is focused on the top surface 130 of the thyristor 100 and at that portion of the region 126 not covered by contact 132 and held constant during the entire etching process.

The hole formed in region 126 is usually elongated or oval in shape and tapers down to a smaller hole of the same elongated or oval shape at its bottom.

The depth of the hole of course is dependent on the self-protected switching voltage desired.

The cavity 150 can be formed if desired by laser drilling through the contact 132, through the auxiliary emitter 126 and into the cathode base 114. This method however is not preferred since it requires a longer period of laser drilling.

A thyristor identical to the type described relative to Figures 2 and 3 was fabricated using processing steps known to those skilled in the art.

The thyristor's structure was as follows:

| | Conductivity Type | Doping Level | Thickness |
|---|---|---|---|
| Cathode Emitter | N | $5 \times 10^{20}$ (surface) | 17 microns |
| Cathode Base | P | $3 \times 10^{17}$ (surface) | 80 microns |
| Anode Base | N | $7 \times 10^{13}$ (uniform) | 260 microns |
| Anode Emitter | P | $3 \times 10^{17}$ (surface) | 80 microns |
| Aux. Emitter | N | $5 \times 10^{20}$ (surface) | 17 microns |

A Tektronix 576 Curve Tracer 140 was electrically connected between the cathode emitter and the anode emitter of the thyristor as shown in Figure 3.

A dielectric mirror rated at 98% reflectivity was used, as a turning mirror, to bend a beam from an Excimer laser, with a krypton fluoride active medium, and to focus the beam, with a calcium fluoride lens having a focal length of 10 cm, on a point located in the center of the exposed portion of the upper surface of the auxiliary emitter 126 (Figure 3).

The beam was focused using trial and error as is well known to those skilled in the art.

The curve tracer was activated to determine the devices original parameters, in this case 1600 $V_{DRM}$. The parameter desired was to have a self-protected switch voltage of 1250 ± 50 volts.

The laser was then operated with a laser energy of 12 millijoules per pulse at 5 hertz for 25 seconds.

At the end of this period the IV characteristic of the device was found to be unchanged.

A flow of argon gas was then initiated through a gas nozzle in proximity to the thyristor at a predetermined rate and the laser was operated at a laser energy of 12 millijoules per pulse at 2 hertz for 23 seconds.

At the end of this period the device was found to have a self-protected switching voltage of 1470 volts.

The laser was then turned on for 3 more pulses at which time the devices self-protected switch voltage was measured at 1290 volts, within the desired range.

The cavity or hole 180 at the surface of auxiliary emitter 126 was found to have an oval or elongated shape. The cavity opening measured 25 mils along its major axis and 15 mils along its minor axis.

The bottom surface of the cavity or hole was also oval or elongated in shape and measured 5 mils along its major axis and 3 mils along its minor axis.

The hole had a depth of 48 microns.

The cavity or hole can be formed without the use of argon gas. However, the temperature stability of the switching voltage is poor. For example, such a device was found to switch at 1600 volts at 25°C junction temperature and 800 volts at 125°C junction temperature. In a device containing a hole formed using an argon atmosphere switching voltage is stable with temperature, typically decreasing only 30 to 60 volts between 25°C and 125°C.

The predetermined optimum flow rate of argon through the nozzle during formation of the cavity or hole in the device is equal to the flow rate of argon required for the laser cuts a hole through a piece of titanium without any discoloration forming on the surface of the titanium.

During the formation of the cavity or hole 150 ejecta 152 (Figure 3) consisting of material removed from the cavity 150 by the laser is deposited around the periphery of the cavity on surface 130 (Figure 3). The ejecta 130 is a disoriented mass which may be left in place without any effect on the device.

The structure of this invention is an improvement over the prior art which was described hereinabove and shown in Figure 1. As shown in Figure 1, the structure consisted of a precisely drilled laser hole in the gate region of a thyristor, with a laser-soldered metal contact in the bottom of the hole and extending up to the surface and making physical and electrical contact with the gate electrode.

The structure, of the present invention, consists of a laser hole in the auxiliary emitter or dynamic-gate region of the thyristor. Since the laser hole has been drilled through the n+ diffusion of the dynamic-gate, no soldered metal contact is needed in this laser hole. Elimination of the metal contact to the bottom of the laser hole is a significant improvement, since the elimination of the metal soldering operation results in improved yields. The new structure has been fabricated with yields that exceeds 95 percent.

The structure of the present invention succeeds in eliminating the soldered-metal contact because the self-protected turn-on occurs through a different principal of operation.

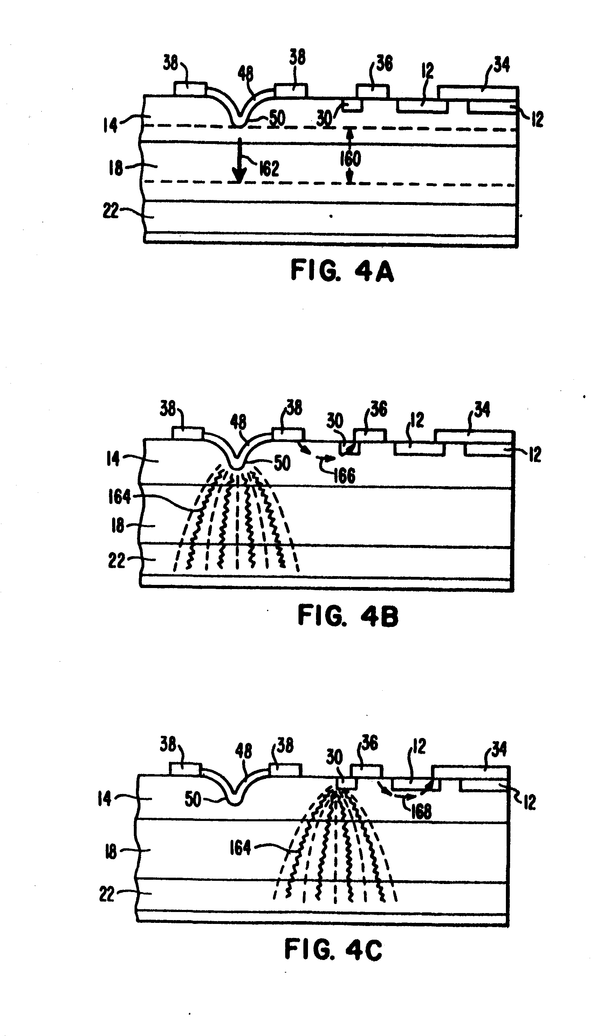

Self-protected turn-on with the prior art structure is illustrated in Figures 4A, 4B, 4C. The reference numerals of Figures 4A, 4B and 4C correspond to those of Figure 1. As shown in Figure 4A, at a high anode bias, which corresponds to the self-protected switching voltage, a space charge region 160 punches through the p-base 14, making contact with the bottom of the laser hole or well 48. A current of electrons 162 flows out of the metal contact 50, across the space charge region 160. This induces a counter flow of holes from the anode-emitter, and a regenerative action creates a plasma 164 under the soldered metal contact 50, as shown in Figure 4B. Then load current 166, flowing out of the gate contact 50 into the dynamic-gate 30, turns on the dynamic-gate. As shown in Figure 4C, once the plasma 164 has formed under the dynamic-gate 30, a current 168 flows out of the dynamic-gate electrode 36 into the main cathode 12, to trigger the main cathode.

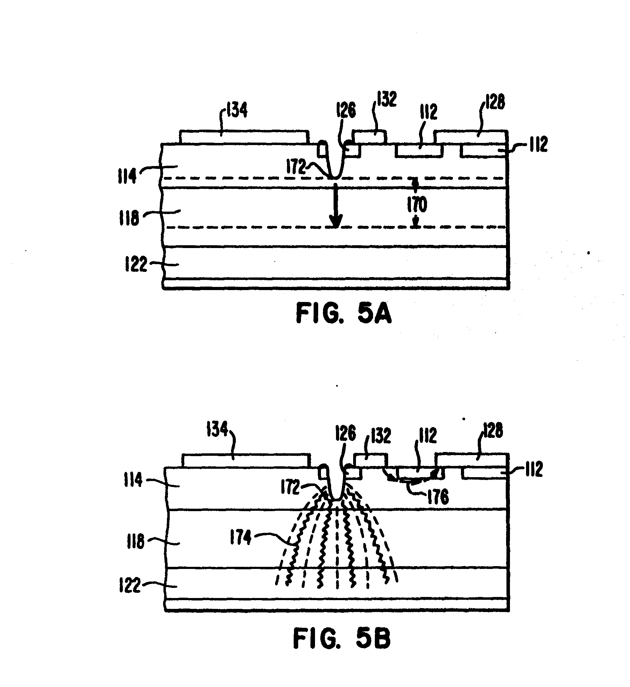

In contrast to the prior art, the turn-on process in the present structure is much simpler and operates in a fashion that eliminates the need for the soldered-metal contact 50. As shown in Figures 5A and 5B, where the reference numerals correspond to those of Figure 3, at a high anode bias, which corresponds to the self-protected switching voltage, space charge region 170 punches through the p-base 114 and contacts bottom 172 of the laser hole 150. This generates an electron current, by surface leakage, from the bottom 172 of the laser hole 150. Again, the counter flow of holes from the anode-emitter 122 creates an electron-hole plasma 174. However, this time the plasma exists between the anode-emitter 122 and the auxiliary emitter or dynamic-gate cathode-emitter 126. As shown in Figure 5B, the plasma 174 provides a current 176 flowing out of the dynamic-gate contact 132 into the main cathode 112, which turns on the main cathode.

The significant difference in the present invention is that the plasma is not concentrated on the bottom of the laser hole. Two factors combine to cause the plasma to spread out: 1) the proximity of the dynamic-gate cathode-emitter diffusion, which is a more efficient emitter than a leaky surface, and 2) current filaments usually have a minimum diameter that is at least as wide as the slice thickness. Since the current does not concentrate on the laser hole, there is a greatly reduced turn-on stress, which eliminates the need for the soldered metal contact.

The operation of the present invention is similar to the prior art, in the sense that self-protected switching is initiated when the space charge region punches through the p-base and makes contact with the bottom of the laser hole. However, the present invention is different in two important respects: 1) the laser hole is located in the n+ diffusion of the dynamic-gate, instead of in the p+ diffusion of the electrical gate and, 2) there is no metal contact to the bottom of the laser hole. Number two is most important from a processing point of view, since it allows a yield in excess of 95 percent.

The most important part of the laser hole is the very bottom. It is the bottom of the hole that provides the self-protected triggering current. Through the use of a scanning transmission electron microscope it was determined that the bottom of the laser hole is single crystal silicon with a leaky surface.

14

CLAIMS:

1. An overvoltage self-protected thyristor which comprises a body of semiconductor material having a top surface, a bottom surface and an edge portion extending between said top and bottom surfaces, characterized in that said thyristor has a cathode base region adjacent to a cathode emitter region, an anode base region adjacent to said cathode base region and an anode emitter region adjacent to said anode base region with a p-n junction between adjacent regions, said cathode emitter region being segmented and extending from said top surface into said body a predetermined first distance, said cathode base region extending from said top surface, where it surrounds said segments of said cathode emitter region, into said body a predetermined second distance, said predetermined second distance being greater than said predetermined first distance, at least one auxiliary gate region extending from said top surface into said body a distance less than said predetermined second distance and being spaced apart from said cathode emitter region and surrounded by said cathode base region within said thyrister, a p-n junction between said auxiliary gate region and said cathode base region, a first metal electrode disposed on and affixed to a portion of said top surface of said body in ohmic electrical contact with a portion of both said cathode emitter region and said cathode base region, a second metal electrode disposed on and affixed to a portion of said top surface of said body in ohmic electrical contact with said cathode base region, and a third metal electrode disposed on and affixed to a portion of said top surface of said body in ohmic electrical contact with a portion of both said auxiliary gate region and said cathode base region, said first, second and third metal electrodes being spaced apart from each other on said top surface, a fourth metal electrode disposed on and affixed to said bottom surface of said body in ohmic electrical contact with said anode emitter region, and walls of said auxiliary gate region forming a cavity within the auxiliary gate region, the cavity extending from the top surface of the body through said auxiliary gate region and into said cathode base region an empirically determined distance.

2. A thyristor according to claim 1, characterized in that the semiconductor material is silicon.

3. A thyristor of claim 1 or 2, characterized in that the cavity extends from that portion of the top surface of the body where said auxiliary gate region is exposed and free of any ohmic electrical contact through said auxiliary gate region and into said cathode base region.

4. A thyristor according to claim 1, 2 or 3, characterized in that the auxiliary gate region extends into the cathode base region a distance equal to the predetermined first distance.

5. A thyristor according to any of claims 1 to 4, characterized in that the empirical determined distance is such that a space charge region of the p-n junction between the cathode base region and the anode base region contact the bottom surface of the cavity at a predetermined break overvoltage.

6. A process for providing overvoltage self-protection in a thyristor having a cathode emitter region, a cathode base region, an anode base region, an anode emitter region and an auxiliary gate region disposed within said cathode base region and extending to a major surface of said thyristor, characterized by connecting a means for measuring the IV characteristic of the thyristor between the anode emitter and the cathode emitter of the thyristor and forming a cavity in said auxiliary gate region with a laser while continuing to monitor the IV characteristic of the thyristor.

7. A process according to claim 6, characterized in that the laser is an Excimer laser.

8. A process according to claim 7, characterized in that the Excimer laser has a krypton fluoride active medium.

9. The process of claim 7 or 8 characterized in that the cavity is formed in the presence of an argon atmosphere.

1/3

0209986

FIG. 1
PRIOR ART

FIG. 2

FIG. 3

FIG. 4A

FIG. 4B

FIG. 4C

FIG. 5A

FIG. 5B